# EUROPEAN PATENT SPECIFICATION

(11) **EP 0 348 017 B1**
(45) Date of publication and mention of the grant of the patent: **15.12.1993**
(21) Application number: 89202020.7
(22) Date of filing: 30.06.1983
(51) Int. Cl.: H01L 27/02, H03K 19/177, H03K 19/086

(54) **Semiconductor integrated-circuit apparatus**
Integrierte Halbleiterschaltungsanordnung
Dispositif de circuit intégré semi-conducteur

(30) Priority: 30.06.1982 JP 112778/82; 01.07.1982 JP 114241/82; 29.12.1982 JP 233774/82; 29.12.1982 JP 230288/82
(43) Date of publication of application: 27.12.1989
(62) Divisional of application: 83303805.2
(73) Proprietor: FUJITSU LIMITED, Kawasaki-shi, Kanagawa 211 (JP)
(72) Inventor: Sugiyama, Eiji, Kawasaki-shi Kanagawa 214 (JP); Saito, Toshiharu c/o Fujitsu Limited, Kawasaki-shi Kanagawa 211 (JP); Natsume, Mitsuaki, Inabe-gun Mie 511-20 (JP)
(74) Representative: Skone James, Robert Edmund

(56) References cited:
- EP-A- 0 023 118
- US-A- 3 981 070
- REVIEW OF THE ELECTRICAL COMMUNICATIONS LABORATORIES, vol. 26, nos. 9-10, September-October 1978, pages 1325-1338, Tokyo, JP; H. MUKAI et al.: "Master slice ECL LSI"
- PATENT ABSTRACTS OF JAPAN, vol. 6, no. 72 (E-105)[950], 7th May 1982; & JP-A-57 010 946
- IBM TECHNICAL DISCLOSURE BULLETIN, vol. 19, no. 10, March 1977, pages 3741-3742, New York, US; R. NIJHUIS et al.: "Semiconductor chip interface circuit"

## Description

The present invention relates to a semi-conductor integrated circuit which has a device for preventing electrostatic breakdown at the input or output terminal of an ECL gate array.

From Patent Abstracts of Japan, Vol.6, No. 72, (E-105)[950], corresponding to JP-A-57010946, it is known to provide standard cells of resistors to provide protection for different internal circuits on a chip.

IBM Technical Disclosure Bulletin, Vol.19, No.10, p.3741-3742 discloses a standard interface cell for a masterslice chip comprising a transisitor, a Schottky barrier diode and resistors that may be configured either as an input or output buffer and connected to internal cells.

In ECL gate arrays formed in integrated-circuit (IC) LSI elements, the internal elements are apt to breakdown due to static electricity eternally applied via input and output terminals. To prevent such an occurrence, it is known to use a circuit for preventing electrostatic breakdown between the external circuit and the input and output terminals.

Such a circuit has a simple construction and is effective. However, if such circuits are provided in the external portions of a plurality of inputs and outputs of the element, the circuit construction of each element becomes large and the cost thereof is increased. Therefore, a circuit for preventing electrostatic breakdown is included in the internal portions of the element. However, an element such as a gate array can be made to have various functions by changing the wiring. Therefore, whether each terminal of the gate array is an input terminal or an output terminal depends on, which functions are given to the gate array. Further, the construction of a circuit for preventing electrostatic breakdown depends on whether the circuit is used at an input terminal or an output terminal. Therefore, when such circuits are formed specifically for each gate array, two kinds of circuits must be formed depending on whether the circuit is to be used at an input terminal or an output terminal, and the design must be changed in accordance with the functions of the gate array. This not only increases the manufacturing cost but also considerably decreases the generality of the gate array.

The present invention consists in an integrated circuit device formed in a semiconductor substrate and comprising:
a first power supply line formed on the substrate;
a second power supply line formed on the substrate having a different voltage from the first power supply line;
a plurality of emitter-coupled logic gate cells formed on the substrate, each gate cell comprising,
a pair of emitter-coupled transistors having a base and collector, the collectors of the emitter-coupled transistors being operatively connected to the first power supply line,
a current source means, connected between the emitters of the emitter-coupled transistors and the second power supply line, and
an output transistor having a base operatively connected to the collector of one of the emitter-coupled transistors and a collector operatively connected to the first power supply line;
a plurality of input-output pads formed on the substrate and selectively connected to the gate cells;
each input-output pad having a means for preventing electrostatic breakdown formed on the substrate adjacent thereto;
whereby, each means for preventing electrostatic breakdown has an electrostatic breakdown preventing element and a resistor; and either
the input-output pad is connected to the base of the emitter-coupled transistor, the electrostatic breakdown preventing element is connected between the input-output pad and the first power supply line and the resistor is connected between the input-output pad and the base of the emitter-coupled transistor; or
the input-output pad is connected to the emitter of the output transistor, the electrostatic preventing element is connected between the input-output pad and the first power supply line and the emitter of the output transistor is connected to the input-output pad without the resistor.

The use of a common group of elements in the electrostatic preventing means for both the input and the output pads greatly simplifies the manufacture of the chips.

In order that the invention may be better understood some embodiments of the invention will now be described with reference to the accompanying drawings, in which:
Figure 1 is a diagram showing cells in a conventional chip;
Figures 2 and 3 are diagrams of the circuit of an internal cell and an external cell, respectively.
Figure 4 is a plan view showing the relationship between an element for preventing electrostatic breakdown and a pad according to the present invention.
Figure 5 is a plan view of an element for preventing electrostatic breakdown.
Figures 6A is a diagram of one element for preventing electrostatic breakdown, the element being formed from a diode.
Figure 6B is a diagram of another element for preventing electrostatic breakdwon, the element being formed from a transistor.
Figures 7A and 7B are plan patterns showing the relationship between an element for preventing electrostatic breakdown and a pad such as shown in Fig. 6B.

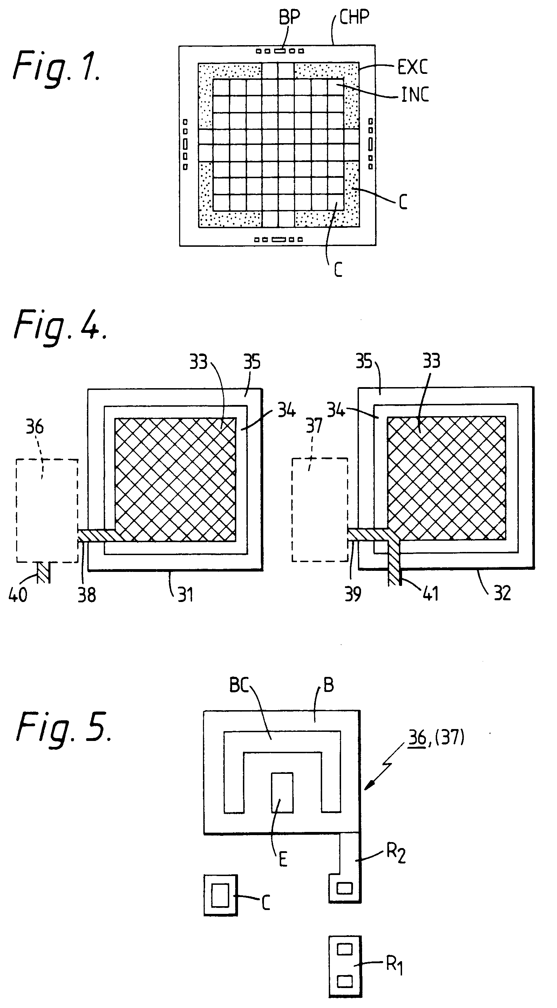

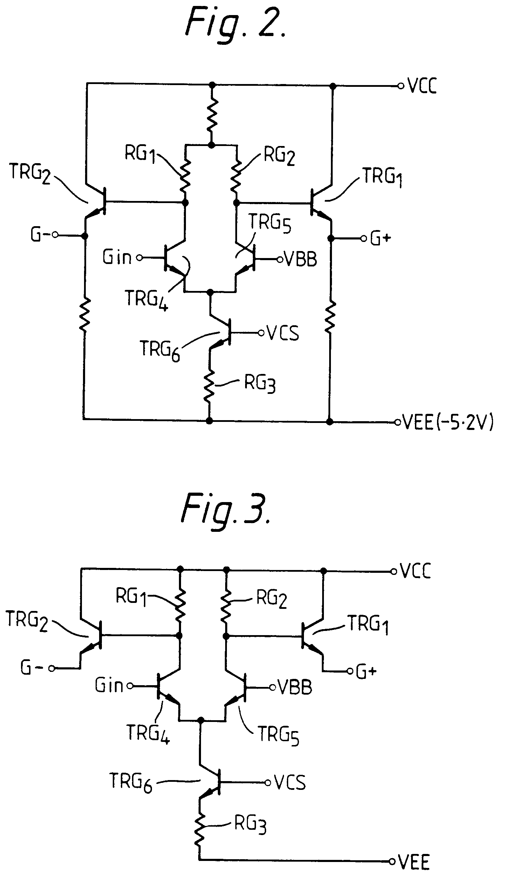

Figure 1 shows the construction of the cells of a master slice LSI circuit and the arrangement of the cells. On a chip CHP of the LSI circuit, cells C are arranged. External cells EXC are arranged around internal cells INC and bonding pads BP are arranged at the periphery of the cells. One cell includes, for example, four OR or NOR gates and a bias circuit. Further details of the cell construction are given in our application EP-A-0098173, from which the present application is divided.

Figure 2 shows a gate circuit included in an internal cell of a chip, with which the present invention may be used. This circuit includes transistors TrG₁, TrG₂, TrG₄ and TrG₅ and resistors RG₁ to RG₃, the base of the transistor TrG₄ being connected to an input Gᵢₙ, the emitter of the transistor TrG₁ providing a positive output G+, and the emitter of the transistor TrG₂ providing a negative output G-. Further, the base of the transistor TrG₅ receives the output V_{BB} of a bias circuit. In the gate circuit shown in Fig. 2, a transistor TrG₆ is inserted between the emitters of the transistors TrG₄, TrG₅ and the resistor RG₃. The gate of the transistor TrG₆ receives a bias input V_{CS} for driving the circuit.

Figure 3 is a gate circuit included in an external cell of a chip and is similar in many respects to the circuit shown in Fig. 2.

Figure 4 shows two bonding pads constituting input and output terminals for an ECL gate array and including devices embodying the present invention for preventing electrostatic breakdown. In Fig. 4, 31 is a bonding pad for an input (hereinafter referred to as an input pad), and 32 is a bonding pad for an output (hereinafter referred to as an output pad). In the input pad 31 and the output pad 32, 33 is a pad portion which consitutes an electrode, a silicon oxide film 34 is fomed under the pad portion 33, and an isolation layer 35 is formed around the silicon oxide film 34.

In combination with the input pad 31, a device 36 for preventing electrostatic breakdown and a connector 38, which connects the device 36 to the pad portion 33, form an input connection. The pad 33 is connected by way of device 36 and connector 38 and a connector 40 to an internal ECL gate array element. In combination with the output pad 32, a device 37 for preventing electrostatic breakdown is connected to the pad portion 33 by a connector 39, thereby forming an output connection. The output pad 32 is connected via connector 41 to an internal ECL gate array element. The device 36 and the device 37 have the same construction, that is, they incorporate the same group of elements. However, the connections of these elements are different depending on whether they are used with the input pad or the output pad. Further, these devices 36 and 37 are arranged between the bonding pads so that the area occupied by the circuit can be decreased.

Figure 5 is a plan view of a device 36, 37 for preventing electrostatic breakdown, showing the group of elements which constitute a common input/output device. B is a base region of the transistor, E is an emitter of the transistor, C is a collector of the transistor, BC is an electrode window for the base, and R₁ and R₂ are resistors. This arrangement is used for both the input pad and the output pad.

The manner in which the elements of the circuit for preventing electrostatic breakdown are used for the input pad and the output pad will now be explained.

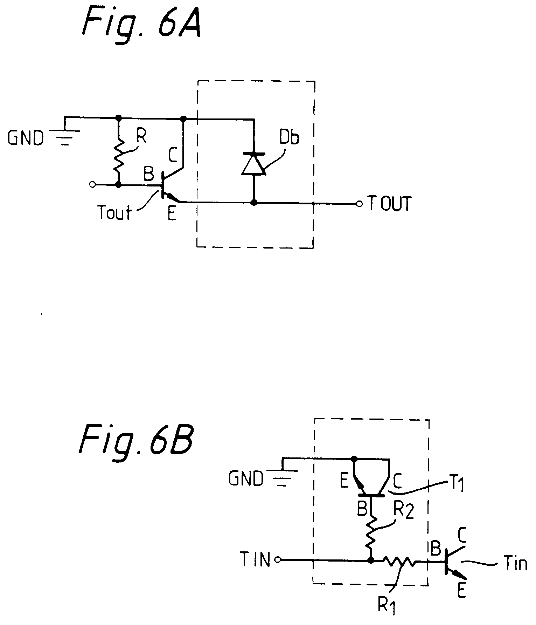

Figure 6A is one example of the construction of a circuit for preventing electrostatic breakdown, employing a diode, for use with an output pad; the resistors of the component group are not employed. The output terminal T_{OUT} is connected to a transistor Tₒᵤₜ in the terminal gate array (corresponding to TRG₁, TRG₂ of Fig. 3) and also is connected, via the diode D_{b}, to ground. In such a circuit, if the output terminal T_{OUT} is positively charged electric charges flow via the diode D_{b} to ground so that the transistor Tₒᵤₜ etc. can be protected by preventing a reverse voltage from being applied to the transistor Tₒᵤₜ. If the output terminal T_{OUT} is negatively charged, the charges flow from ground, via the resistor R and the transistor Tₒᵤₜ , to the output terminal T_{OUT}.

In Fig. 6B, a circuit for preventing electrostatic breakdown used for an input pad is formed with a transistor, as in Fig. 5, and the portion surrounded by the broken line is a circuit corresponding to that of Fig. 5. An input terminal T_{IN} is connected, via the resistor R₁, to a transistor Tᵢₙ in the ECL gate array (corresponding to TRG₄, Fig. 2) and is also connected, via the resistor R₂ , to a base of a transistor T₁. An emitter and a collector of the transistor T₁ are connected to ground. By such a construction, the base and the emitter of the transistor T₁ have the same function as the diode D_{b} in Fig. 6A, namely to act as a circuit for preventing electrostatic breakdown. Further, the transistor T₁ acts as a capacitor, so that it forms an RC circuit with the resistors R₁, R₂ and acts as a circuit for preventing oscillation of the input signal.

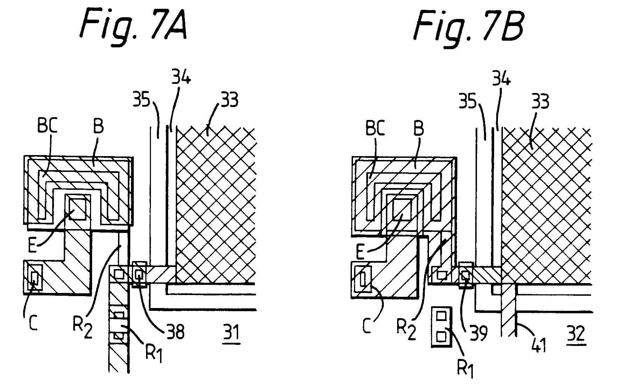

Figure 7A is an example in which a circuit for preventing electrostatic breakdown used for an input pad and a circuit for preventing oscillation shown in Fig. 6B are formed by the elements shown in Fig. 5. In Fig. 7A, the emitter E and the collector C are connected to ground. An electrode BC in the base region B is connected to one terminal of the resistor R₂, and another terminal of the resistor R₂ is connected to a terminal of the resistor R₁ and to the bonding pad 31 for the input via connector 38. Another terminal of the resistor R₁ is connected to an internal element of the terminal gate array. Using such a construction with the input pad 31, a circuit for preventing electrostatic breakdown and a circuit for preventing oscillation are formed with the elements shown in Fig. 5.

Figure 7B is an example in which another circuit for preventing electrostatic breakdown is formed from the elements shown in Fig. 5, for use with an output pad 32. In Fig. 7B, the emitter E and the collector C are connected to ground. An electrode BC in the base region B and the resistor R₂ are short-circuited with aluminium and are connected, via the connector 39, to the bonding pad 32, for the output and via the connector 41 to an internal element of the terminal gate array. By using such a construction, a circuit for preventing electrostatic breakdown used for an output pad can also be formed from the elements shown in Fig. 5.

Further, in Figs. 7A and 7B, the connectors 38, 39, and 41 which are connected to a bonding pad, are formed by passing them over the isolation layer 35, and the oxide film on the isolation layer is thin. Therefore, two-layer wiring is always carried out so as to increase the breakdown voltage of the oxide film.

## Claims

1. An integrated circuit device formed in a semiconducter substrate and comprising:
a first power supply line (Vcc) formed on the substrate;
a second power supply line (VEE) formed on the substrate having a different voltage from the first power supply line;
a plurality of emitter-coupled logic gate cells formed on the substrate, each gate cell comprising,
a pair of emitter-coupled transistors (TRG₄,TRG₅) having a base and collector, the collectors of the emitter-coupled transistors being operatively connected to the first power supply line,
a current source means (TRG₆), connected between the emitters of the emitter-coupled transistors and the second power supply line (VEE), and
an output transistor (TRG₂) having a base operatively connected to the collector of one of the emitter coupled transistors and a collector operatively connected to the first power supply line (Vcc);
a plurality of input-output pads (31,32) formed on the substrate and selectively connected to the gate cells;
each input-output pad having a means (36,37) for preventing electrostatic breakdown formed on the substrate adjacent thereto;
whereby each means for preventing electrostatic breakdown has an electrostatic breakdown preventing element (D_{b},T₁) and a resistor (R₁); and either
the input-output pad (31) is connected to the base of the emitter-coupled transistor (Tᵢₙ, TRG₄), the electrostatic breakdown preventing element (36) is connected between the input-output pad and the first power supply line and the resistor (R₁) is connected between the input-output pad (31) and the base of the emitter-coupled transistor; or
the input-output pad (32) is connected to the emitter of the output transistor (Tₒᵤₜ, TRG₂) the electrostatic preventing element (37) is connected between the input-output pad (32) and the first power supply line and the emitter of the output transistor is connected to the input-output pad without the resistor.

2. An integrated circuit device according to the claim 1 in which the electrostatic breakdown preventing element comprises a diode (D_{b}).

3. An integrated circuit device according to the claim 1, in which the electrostatic breakdown preventing element comprises a transistor (T₁).

## Patentansprüche

1. Integrierte Schaltungsanordnung, gebildet in einem Halbleiter und umfassend:
eine erste Energieversorgungsleitung (Vcc), die auf dem Substrat gebildet ist;
eine zweite Energieversorgungsleitung (VEE), die auf dem Substrat gebildet ist und eine andere Spannung als die erste Energieversorgungsleitung hat;
eine Vielzahl von emittergekoppelten Logikgatezellen, die auf dem Substrat gebildet sind, von denen jede Gatezelle umfaßt,
ein Paar on emittergekoppelten Transistoren (TRG₄, TRG₅) mit einer Basis und einem Kollektor, von denen die Kollektoren der emittergekoppelten Transistoren operativ mit der erten Energieversorgungs- leitung verbunden sind,
ein Stromquellenmittel (TRG₆); das zwischen den Emittern des emittergekoppelten Transistors und der zweiten Energieversorgungsleitung (VEE) verbunden ist, und
einen Ausgangstransistor (TRG₂), der eine Basis hat, die operativ mit dem Kollektor eines der emittergekoppelten Transistoren verbunden ist, und einen Kollektor, der operativ mit der ersten Energieversorgungsleitung (Vcc) verbunden ist;
eine Vielzahl von Eingangs-Ausgangs-Feldern (31, 32) die auf dem Substrat gebildet und selektiv mit den Gatezellen verbunden sind, von denen jedes Eingangs-Ausgangs-Feld ein Mittel (36, 37) zur Verhinderung elektrostatischen Durchbruchs auf dem Substrat und daran angrenzend ausgebildet hat;
wodurch jedes Mittel zur Verhinderung eines elektrostatischen Durchbruchs ein Elektrostatikdurchbruchs-Verhinderungselement (D_{b}, T₁) und einen Widerstand (R₁) umfaßt, und entweder
das Eingangs-Ausgangs-Feld (31) ist mit der Basis des emittergekoppelten Transistors (Tᵢₙ, TRG₄) verbunden, das Elektrostatikdurchbruchs-Verhinderungselement (36) ist zwischen dem Eingangs-Ausgangs-Feld und der ersten Energieversorgungsleitung verbunden und der Widerstand (R₁) ist zwischen dem Eingangs-Ausgangs-Feld (31) und der Basis des emittergekoppelten Transistors verbunden; oder
das Eingangs-Ausgangs-Feld (32) ist mit dem Emitter des Ausgangstransistors (Tₒᵤ, TRG₂) verbunden ist, das Elektrostatikdurchbruchs-Verhinderungselement (37) ist zwischen dem Eingangs-Ausgangs-Feld (32) und der ersten Energieversorgungsleitung verbunden ist und der Emitter des Ausgangstransistors ist mit dem Eingangs-Ausgangs-Feld ohne den Widerstand verbunden ist.

2. Integrierte Schaltungsanordnung nach Anspruch 1, bei der das Elektrostatikdurchbruchs-Verhinderungselement eine Diode (D_{b}) umfaßt.

3. Integrierte Schaltungsanordnung nach Anspruch 1, bei der das Elektrostatikdurchbruchs-Verhinderungselement einen Transistor (T₁) umfaßt.

## Revendications

1. Dispositif à circuit intégré formé sur un substrat semi-conducteur et comprenant :
un première ligne d'alimentation en courant (Vcc) formée sur le substrat ;
une seconde ligne d'alimentation en courant (VEE) formée sur le substrat ayant une tension différente de la première ligne d'alimentation en courant ;
une pluralité de cellules de portes, à logique à liaison par les émetteurs, formées sur le substrat, chaque cellule de portes comprenant :
une paire de transistors reliés par les émetteurs (TRG₄, TRG₅) ayant une base et un collecteur, les collecteurs des transistors reliés par les émetteurs étant connectés de façon fonctionnelle à la première ligne d'alimentation en courant ;
un moyen formant source de courant (TRG₆), connecté entre les émetteurs des transistors reliés par les émetteurs et la seconde ligne d'alimentation en courant (VEE) ; et,
un transistor de sortie (TRG₂) dont la base est connectée de façon fonctionnelle au collecteur de l'un des transistors reliés par les émetteurs et dont le collecteur est connecté de façon fonctionnelle à la première d'alimentation en courant (Vcc) ;
une pluralité de plots d'entrée/sortie (31, 32) formés sur le substrat et connectés de manière sélective aux cellules de portes ;
chaque plot d'entrée/sortie comportant, formé à côté de lui sur le substrat, un moyen (36, 37) pour empêcher le claquage électrostatique ;
ce par quoi le moyen pour empêcher le claquage électrostatique possède un élément de prévention de claquage électrostatique (D_{b}, T₁) et une résistance (R₁) ; et soit,
le plot d'entrée/sortie (31) est connecté à la base du transistor relié par les émetteurs (Tᵢₙ, TRG₄), l'élément de prévention de claquage électrostatique (36) est connecté entre le plot d'entrée/sortie et la première ligne d'alimentation en courant, et la résistance (R₁) est connectée entre le plot d'entrée/sortie (31) et la base du transistor couplé par les émetteurs ; soit,
le plot d'entrée/sortie (32) est connecté à l'émetteur du transistor de sortie (Tₒᵤₜ, TRG₂), l'élément de prévention de claquage électrostatique (37) est connecté entre le plot d'entrée/sortie (32) et la première ligne d'alimentation en courant, et l'émetteur du transistor de sortie est connecté au plot d'entrée/sortie sans la résistance.

2. Dispositif à circuit intégré selon la revendication 1, dans lequel l'élément de prévention de claquage électrostatique comprend une diode (D_{b}).

3. Dispositif à circuits intégrés selon la revendication 1, dans lequel l'élément de prévention de claquage électrostatique comprend un transistor (T₁).
